(19) Europäisches Patentamt / European Patent Office / Office européen des brevets

(11) **EP 2 791 907 B1**

## (12) FASCICULE DE BREVET EUROPEEN

(45) Date de publication et mention de la délivrance du brevet:
**20.03.2024 Bulletin 2024/12**

(21) Numéro de dépôt: **12824690.7**

(22) Date de dépôt: **11.12.2012**

(51) Classification Internationale des Brevets (IPC):
**G06T 11/00** *(2006.01)* **G01R 33/56** *(2006.01)*

(52) Classification Coopérative des Brevets (CPC):
**G06T 11/006; G01R 33/5608;** G06T 2211/424

(86) Numéro de dépôt international:
**PCT/FR2012/052868**

(87) Numéro de publication internationale:
**WO 2013/088050 (20.06.2013 Gazette 2013/25)**

(54) **PROCÉDÉ DE RECONSTRUCTION D'UN SIGNAL EN IMAGERIE MÉDICALE À PARTIR DE MESURES EXPÉRIMENTALES PERTURBÉES, ET DISPOSITIF D'IMAGERIE MÉDICALE METTANT EN ŒUVRE CE PROCÉDÉ**

VERFAHREN ZUR REKONSTRUKTION EINES SIGNALS IN DER MEDIZINISCHEN BILDGEBUNG AUF DER BASIS VON GESTÖRTEN EXPERIMENTELLEN MESSUNGEN UND MEDIZINISCHE BILDGEBUNGSVORRICHTUNG MIT DIESEM VERFAHREN

METHOD OF RECONSTRUCTING A SIGNAL IN MEDICAL IMAGING ON THE BASIS OF PERTURBED EXPERIMENTAL MEASUREMENTS, AND MEDICAL IMAGING DEVICE IMPLEMENTING THIS METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2011 FR 1161486**

(43) Date de publication de la demande:
**22.10.2014 Bulletin 2014/43**

(73) Titulaires:
• **Université de Lorraine**
**54052 Nancy Cedex (FR)**
• **Centre Hospitalier Régional de Nancy**
**54035 Nancy (FR)**

(72) Inventeurs:
• **MENINI, Anne**
**80802 München (DE)**
• **FELBLINGER, Jacques**
**54850 Mereville (FR)**
• **ODILLE, Freddy**
**54520 Laxou (FR)**
• **VUISSOZ, Pierre-André**
**54600 Villers Les Nancy (FR)**

(74) Mandataire: **IPAZ**
**Bâtiment Platon**
**Parc Les Algorithmes**
**91190 Saint-Aubin (FR)**

(56) Documents cités:
**WO-A2-2009/098371**

• **ODILLE F ET AL: "Generalized reconstruction by inversion of coupled systems (GRICS) applied to free-breathing MRI", MAGNETIC RESONANCE IN MEDICINE, ACADEMIC PRESS, DULUTH, MN, US, vol. 60, 25 juin 2008 (2008-06-25), pages 146-157, XP002537561, ISSN: 0740-3194, DOI: 10.1002/MRM.21623**
• **Erik H. W. Meijering ET AL: "A fast technique for motion correction in DAS using a feature-based, irregular grid", Medical Image Computing and Computer-Assisted Interventention - MICCAI'98, 13 octobre 1998 (1998-10-13), pages 590-597, XP055030035, DOI: 10.1007/BFb0056244 Extrait de l'Internet: URL:http://www.springerlink.com/content/pu 45961r9x7327v5/fulltext.pdf [extrait le 2012-06-15]**

## Description

### Domaine technique

La présente invention concerne un procédé de reconstruction d'un signal en imagerie médicale à partir de mesures expérimentales perturbées par des mouvements du sujet ou d'autres sources de perturbation. Elle concerne également un dispositif d'imagerie médicale mettant en oeuvre le procédé.

Le domaine de l'invention est plus particulièrement mais de manière non limitative celui de l'imagerie médicale et de l'imagerie des milieux biologiques.

### Etat de la technique antérieure

Il existe une pluralité de techniques d'imagerie qui permettent d'obtenir des informations avec des représentations bidimensionnelles (2D) et/ou tridimensionnelles (3D) de l'intérieur d'un organisme biologique. Ces informations peuvent être représentatives de structures et/ou de fonctions biologiques de cet organisme.

Nous regroupons de manière non limitative ces techniques d'imagerie sous le nom de techniques d'imagerie médicale. L'organisme biologique imagé, vivant ou mort, humain ou non, est appelé de manière non limitative le sujet.

Certaines techniques, telles que par exemple l'imagerie par résonnance magnétique nucléaire (IRM), la tomographie par scanner à rayons X et l'imagerie par émission de positrons (TEP), nécessitent des acquisitions séquentielles de données pendant des temps parfois longs. Les images sont ensuite reconstruites par calcul à partir de ces données.

La reconstruction des images peut être significativement dégradée par les mouvements du sujet pendant l'acquisition, dans la mesure où les structures imagées se déforment au cours du temps. On rencontre ce problème par exemple lors d'acquisitions d'images IRM dans la région du coeur ou du thorax, à cause notamment des battements cardiaques et des mouvements respiratoires.

Il est connu de mesurer ces mouvements physiologiques pendant les acquisitions, au moyen de capteurs additionnels (électrocardiogrammes, accéléromètres, ceintures pneumatiques, ...) et/ou de séquences d'acquisition spécifiques du système d'imagerie (écho-navigateurs, images partielles en imagerie IRM) pour les prendre en compte dans les processus d'acquisition et/ou de traitement des données d'imagerie.

Selon certaines techniques connues, les mesures de mouvements physiologiques sont utilisées pour synchroniser les acquisitions avec ces mouvements. Ces techniques sont toutefois limitées au traitement de mouvements périodiques (battements cardiaques) dans des limites assez contraignantes.

Selon d'autres techniques connues, les mesures de perturbations (mouvements, ...) sont utilisées pour générer des modèles de déformations intégrés dans le calcul des images.

On connaît en particulier les documents WO 2009/098371 et Odille F. et al: "Generalized reconstruction by inversion of coupled systems (GRICS) applied to free-breathing MRI", Magnetic Résonance in Medicine, vol. 60, pages 146-157, 2008, qui décrivent un procédé de reconstruction d'un signal ou d'une image dans un dispositif d'imagerie médical à partir de mesures perturbées.

Ce procédé décrit l'utilisation d'un modèle des perturbations, tel que par exemple un modèle paramétrique décrivant les mouvements physiologiques élastiques à partir de données expérimentales issues de capteurs de mouvement, qui est construit de telle sorte à inclure les perturbations dans le problème de reconstruction du signal. Le modèle paramétrique décrivant les perturbations est couplé à un modèle paramétrique simulant le signal sans perturbation à reconstruire. Ces deux modèles sont optimisés de manière couplée dans un processus itératif.

Un procédé tel que décrit dans WO 2009/098371 nécessite la résolution de systèmes linéaires, dont l'un modélisant les mouvements, par des algorithmes d'optimisation itératifs.

Lorsque l'on résout une équation linéaire, deux problèmes peuvent se poser :

- Le nombre important d'inconnues qui induit des difficultés de convergence de l'optimisation ;
- L'utilisation d'une régularisation explicite qui peut fausser la convergence de l'algorithme ;

Le nombre d'inconnues peut être particulièrement élevé dans un modèle paramétrique décrivant les perturbations ou les mouvements. Il faut évaluer les différentes composantes du déplacement, dues à chaque mouvement physiologique indépendant, et ce, pour chaque voxel. Le nombre d'inconnues du système linéaire est donc par exemple le suivant : taille de l'image x nombre de degrés de liberté du mouvement x nombre de capteurs physiologiques. Par exemple, pour une image de taille 256x256, avec 2 directions de déplacement (X et Y) et pour 4 mouvements physiologiques (respiration thoracique et abdominale et leurs dérivées), l'algorithme doit trouver environ 500 000 inconnues. Si maintenant on souhaite faire le même traitement sur des données 3D, pour un volume de taille 256x256x64, avec 3 directions de déplacement (X, Y et Z) et pour 4 mouvements physiologiques, l'algorithme doit trouver plus de 50 millions d'inconnues.

Avec un algorithme d'optimisation linéaire, plus le nombre d'inconnues augmente, plus la convergence de l'optimisation est difficile (temps de calculs longs, convergence vers des minima locaux, instabilité numérique et imprécision de la solution, etc.). Le problème se pose donc pour des reconstructions 2D avec une résolution spatiale fine ou encore avec une description du mouvement physiologique avec de nombreuses composantes. Le problème se pose également très rapidement pour des reconstructions en 3D.

Le problème comprend en général plus d'inconnues indépendantes que de données d'entrée indépendantes. Il peut être plus ou moins mal posé au sens de la définition de Hadamar. Lorsqu'un problème est mal posé, plusieurs solutions peuvent y répondre. Certaines peuvent même parfois être aberrantes.

Afin de faciliter la convergence d'un algorithme d'optimisation linéaire, le principe de la régularisation est souvent employé. Elle consiste à appliquer une contrainte supplémentaire à la solution d'un problème afin de limiter le nombre de solutions à celles qui sont réalistes. Par exemple, une régularisation peut consister à ne limiter les déplacements qu'à ceux qui sont relativement lisses ou réguliers (en appliquant par exemple des contraintes sur les gradients d'un champ de déplacement).

Ainsi, lorsqu'on emploie une régularisation explicite, la solution du système linéaire est celle qui répond à la fois à l'équation linéaire, mais qui respecte dans le même temps la contrainte de régularisation explicite.

La contrainte utilisée pour régulariser l'optimisation des modèles de mouvement consiste à ne limiter les déplacements qu'à ceux qui sont relativement lisses ou réguliers (en appliquant des contraintes sur les gradients du champ de déplacement). Mais si cette contrainte est réellement vérifiée au sein d'un tissu, elle ne l'est pas forcément à l'interface entre les organes. Ceux-ci peuvent glisser les uns contre les autres par exemple. Localement, le modèle de mouvement ne vérifie alors plus la contrainte de régularisation.

Autrement dit, avec la méthode explicite de régularisation telle qu'on la retrouve dans l'art antérieur, le compromis que l'on doit faire entre la capacité de convergence et la justesse de la solution est très pénalisant.

Le document Erik H. W. Meijering et al: "A fast technique for motion correction in DAS using a feature-based, irregular grid", Medical Image Computing and Computer-Assisted Intervention - MICCAI'98, Lecture Notes in Computer Science (LNCS), volume 1496, 2006, décrit une technique d'angiographie dans laquelle un champ vectoriel de déplacement est déterminé par sélection de points caractéristiques de l'image, et recherche du déplacement d'une fenêtre de correspondance pour chaque point. Des histogrammes de différence peuvent notamment être utilisés pour rechercher les fenêtres de correspondance.

Un objet de la présente invention est de proposer un procédé de modélisation des mouvements physiologiques exploitable dans le cadre du traitement des données d'imagerie médicale, qui résolve les problèmes mentionnés, en particulier de nombre d'inconnues et de convergence.

Un autre objet de la présente invention est de proposer un procédé de traitement de données d'imagerie médicale, en particulier d'IRM, apte à prendre en compte les mouvements du patient.

Un autre objet de la présente invention est de proposer un procédé de traitement de données d'imagerie médicale, en particulier d'IRM, apte à être mis en oeuvre dans le cadre d'une imagerie 3D.

**Exposé de l'invention**

Cet objectif est atteint avec un procédé de reconstruction de signaux d'imagerie en milieu biologique selon la revendication 1.

Les points sélectionnés pour construire la grille d'échantillonnage de mouvement peuvent comprendre en particulier des points de la grille d'échantillonnage d'imagerie, et/ou des points choisis dans une zone couverte par la grille d'échantillonnage d'imagerie.

Les points sélectionnés pour construire la grille d'échantillonnage de mouvement peuvent être choisis en fonction de : (i) leur proximité avec des zones d'interfaces entre des structures ou organes du milieu biologique et (ii) leur proximité avec des zones du milieu biologique affectées par des variations de mouvements et/ou des déformations locales comparativement plus importantes.

La construction de la grille d'échantillonnage de mouvement peut comprendre en outre des étapes de :

- classification des points de la grille d'échantillonnage d'une image du milieu biologique préalablement obtenue selon un critère de proximité représentatif de leur proximité avec des zones d'interfaces entre des structures ou organes du milieu biologique, de telle sorte à en constituer une liste,
- définition de zones de sécurité autour des points de la grille d'échantillonnage d'imagerie, dont l'étendue est une fonction inverse de la variation du mouvement calculé avec le modèle de mouvement, et
- constitution de la grille d'échantillonnage de mouvement en parcourant la liste des points classifiés à partir des points les plus proches des zones d'interfaces entre des structures ou organes du milieu biologique, et en ne conservant en vue de la construction de la grille d'échantillonnage de mouvement que les points pour lesquels aucun point appartenant déjà à la grille d'échantillonnage de mouvement ne se trouve dans leur zone de sécurité.

Les zones de sécurité peuvent être notamment rectangulaires, circulaires ou elliptiques.

Elles peuvent être définies de telle sorte que leur étendue selon les axes de la grille d'échantillonnage est une fonction inverse de la variation du mouvement calculé avec le modèle de mouvement selon lesdits axes.

La grille d'échantillonnage de mouvement peut comprendre des points issus de la liste des points classifiés, et/ou des points situés à proximité de points de la liste des points classifiés.

Suivant des modes de réalisation,

- la valeur du critère de proximité peut être sensiblement proportionnelle à la norme du gradient de l'image au point considéré ;
- l'étendue de la zone de sécurité selon les axes de la grille peut être une fonction inverse du gradient du mouvement selon lesdits axes respectifs.

Le procédé selon l'invention peut comprendre en outre une étape de détermination des paramètres de mouvement aux points de la grille d'échantillonnage d'imagerie par interpolation des valeurs calculées aux points de la grille d'échantillonnage de mouvement.

Il peut comprendre en outre une étape de calcul d'une matrice d'interpolation faisant le lien entre les paramètres du modèle de mouvement aux points de la grille d'échantillonnage de mouvement et aux points de la grille d'échantillonnage d'imagerie, lequel calcul de matrice d'interpolation comprenant des étapes :

- de réalisation d'une triangulation de Delaunay entre les points de la grille d'échantillonnage de mouvement, de telle sorte que les points de la grille d'échantillonnage d'imagerie n'appartenant pas à la grille d'échantillonnage de mouvement soient inclus respectivement dans un seul triangle dans le cas d'une image 2D, ou un seul tétraèdre dans le cas d'une image 3D, dont les sommets sont des points de la grille d'échantillonnage de mouvement,
- de calcul, pour chaque point considéré de la grille d'échantillonnage d'imagerie, de coefficients de pondération barycentriques relatifs aux sommets du triangle ou du tétraèdre incluant ledit point, définissant la position dudit point relativement auxdits sommets.

Suivant des modes de réalisation, le procédé selon l'invention peut mettre en oeuvre des mesures représentatives d'une pluralité de mouvements physiologiques, et une pluralité de modèles de mouvement associés auxdits mouvements physiologiques, et comprendre des étapes de construction d'une pluralité de grilles d'échantillonnage de mouvement pour les différents mouvements physiologiques, et de calcul de paramètres respectifs de mouvement selon lesdites grilles.

Suivant des modes de réalisation,

- la reconstruction des signaux d'imagerie peut comprendre une étape d'inversion d'un système linéaire décrivant une relation entre les mesures expérimentales et les images, et prenant en compte des paramètres de mouvement préalablement déterminés aux points de la grille d'échantillonnage d'imagerie ;
- le calcul de paramètres de mouvement aux points de la grille d'échantillonnage de mouvement peut comprendre une étape d'inversion d'un système linéaire décrivant une relation entre, d'une part, une erreur entre des mesures expérimentales et des mesures estimées à partir de signaux d'imagerie reconstruit, et d'autre part d'erreurs sur les paramètres de mouvement préalablement calculés ;
- l'inversion du système linéaire décrivant une relation entre les erreurs de mesure et les erreurs sur les paramètres de mouvement peut être effectuée sans régularisation explicite.

Le procédé selon l'invention peut comprendre en outre une répétition itérative des étapes de reconstruction des signaux d'imagerie et de calcul de paramètres de mouvement.

Le procédé selon l'invention peut comprendre en outre une répétition itérative des étapes de reconstruction des signaux d'imagerie et de calcul de paramètres de mouvement, pour des grilles d'échantillonnage d'imagerie de résolutions spatiales croissantes.

Suivant des modes de mise en oeuvre, le procédé selon l'invention peut être appliqué à :

- la reconstruction de signaux d'imagerie sous une forme choisie parmi un voxel, une image, une série d'images, un volume IRM, et une série de volumes IRM ;
- la reconstruction de signaux d'imagerie sous la forme d'au moins un spectre d'au moins un voxel de spectroscopie par RMN ;
- la reconstruction de signaux d'imagerie sous une forme choisie parmi un voxel, une image, une série d'images, un volume et une série de volumes, issu d'au moins un processus d'acquisition d'images médicales parmi l'IRM, la tomographie par rayons X, la Tomographie par Emission de Positons, la tomographie d'émission monophotonique et l'échographie.

Suivant un autre aspect, il est proposé un dispositif d'imagerie médicale mettant en oeuvre le procédé de reconstruction de signaux d'imagerie selon l'invention.

Il est également proposé :

- un dispositif comprenant des moyens d'imagerie IRM et mettant en oeuvre le procédé selon l'invention ;
- Un dispositif comprenant des moyens d'imagerie spectroscopique par RMN et mettant en oeuvre le procédé selon l'invention.

Un aspect avantageux de l'invention consiste en une modification de la qualité locale de la description des champs de déplacements du milieu biologique, par le biais des modèles de mouvement et/ou déformation. Le fait de passer d'une structure homogène (une carte de déplacement avec une description en chaque pixel/voxel) à une structure hétérogène (une grille irrégulière de points judicieusement choisis) permet de diminuer considérablement le nombre d'inconnues du problème.

Par nature, certaines zones des modèles de déplacement sont lisses. Par exemple, deux éléments de tissus adjacents auront un mouvement très corrélé s'ils appartiennent à la même structure. En revanche, deux éléments de tissus correspondant à l'interface entre deux structures peuvent avoir des déplacements indépendants. L'idée est donc d'utiliser peu de points pour décrire les zones où le mouvement est très corrélé et plus de points là où le mouvement est complexe. On constitue ainsi une grille d'échantillonnage de mouvement irrégulière. De cette façon, on place chaque partie de l'objet sous les conditions les plus favorables pour l'évaluation du déplacement par une méthode d'optimisation.

Ainsi, on peut se contenter de calculer le modèle de mouvement uniquement sur les points de la grille d'échantillonnage de mouvement irrégulière. Ensuite, le modèle de déplacement peut être retrouvé en n'importe quel point à l'aide d'une interpolation. De cette manière, on peut diminuer drastiquement le nombre d'inconnues du problème sans pour autant diminuer la qualité de la description du modèle de mouvement.

On peut également considérer la méthode selon l'invention comme un moyen de régularisation implicite. En effet, on n'applique de contrainte directe sur la solution que l'on cherche. La contrainte est appliquée indirectement par la grille irrégulière : seules les zones présentant une faible densité de points induisent un lissage local du champ de déplacement. On a donc diminué le nombre de solutions possibles.

Mais surtout, la dimension, i.e. le nombre d'inconnues, de la solution recherchée est diminuée. La stabilité numérique de la convergence est donc grandement améliorée.

Un aspect important est la sélection des points qui vont constituer la grille d'échantillonnage de mouvement. On a vu que pour ne pas perdre d'information, la répartition des points doit s'adapter à la fois à l'anatomie (plus de points à l'interface entre les structures) et à la physiologie (plus de points là où le mouvement est complexe). Dans la mesure où le problème s'inscrit dans un processus de reconstruction itératif, on peut se baser sur des estimations préalables de l'image reconstruite et du modèle de mouvement pour déterminer la grille la plus optimale : une grille adaptée à l'anatomie et à la physiologie.

Un avantage de l'invention est d'apporter une régularisation adaptative. De cette façon, on ne risque pas d'adopter une régularisation trop contraignante qui risque de compromettre la justesse de la solution et dans le même temps, la régularisation réduit largement le champ des solutions pour améliorer la convergence de l'optimisation.

En outre, le procédé selon l'invention permet de déterminer la meilleure grille de façon analytique, c'est-à-dire directe. Elle n'alourdit donc pas les calculs.

Les avantages de l'invention peuvent être illustrés par le biais d'une analogie avec les réductions de base en algèbre linéaire :

- Comme le nombre d'inconnues est diminué, on améliore la stabilité numérique de l'optimisation. Avec la grille irrégulière, le procédé selon l'invention peut apparaître comme équivalent à un moyen de trouver une famille libre dans laquelle on va chercher la solution du problème plutôt que de la chercher dans une famille liée ;
- Comme la régularisation est adaptée au problème, on ne risque pas de trop contraindre la solution. La convergence ne sera donc pas faussée. Le procédé selon l'invention peut apparaître comme équivalent à une méthode selon laquelle on s'assure de conserver une famille génératrice de vecteur dans laquelle on va chercher la solution du problème ;
- La méthode de régularisation étant adaptative, on diminue le nombre de solutions possibles et on accélère donc la convergence. Le procédé selon l'invention peut apparaître comme équivalent à une méthode permettant de restreindre l'espace vectoriel de recherche à celui des mouvements physiologiques du patient plutôt qu'à n'importe quel champ de déplacement ;
- Une régularisation explicite implique le choix d'un paramètre dit de régularisation $\mu$. Ce choix est en général problématique car il est subjectif (déterminé empiriquement) et non optimal, car il résulte d'un compromis global entre le lissage imposé dans certains tissus et la précision du déplacement. La méthode proposée fournit une règle objective (automatique et adaptative) pour déterminer le positionnement optimal des noeuds de la grille, de façon à produire un lissage « intelligent » en fonction de la position de l'image et du champ de déplacement considérés.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- la figure 1 illustre un mode de réalisation du procédé selon l'invention,
- la figure 2 illustre une grille d'échantillonnage de mouvement selon l'invention, sur une image IRM thoracique.
- la figure 3 illustre un mode de réalisation du procédé selon l'invention, sous la forme d'itérations multi-résolutions.

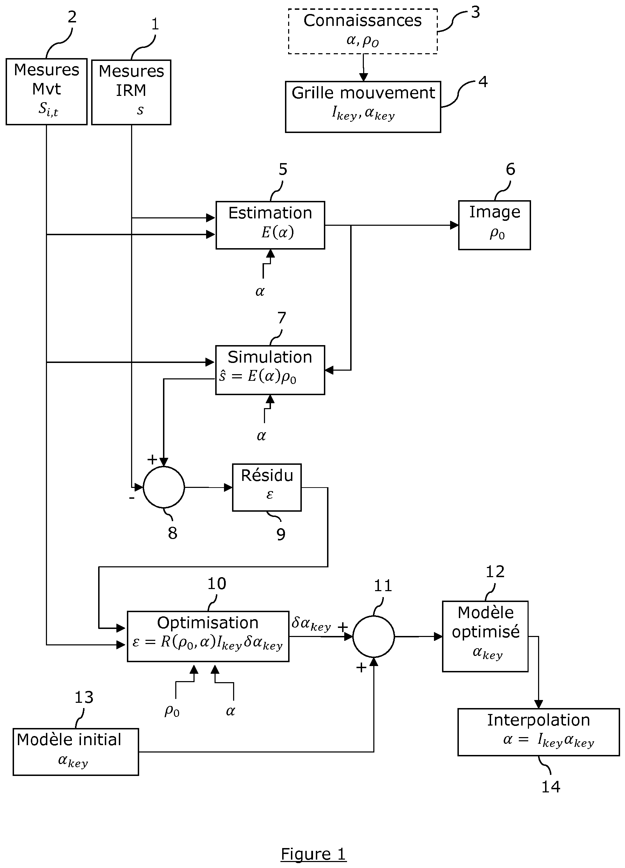

En référence à la figure 1, on va décrire un mode de mise en oeuvre de procédé selon l'invention pour la reconstruction de signaux d'imagerie IRM 6, à partir de mesures expérimentales 1 obtenues avec un système d'Imagerie par Résonance Magnétique (IRM).

Ce mode de mise en oeuvre est dérivé du procédé de reconstruction de signaux d'imagerie IRM tel décrit dans le document WO 2009/098371.

Les données d'entrées comprennent des mesures expérimentales 1, notées s, acquises par le système IRM sur un sujet. Le sujet peut être par exemple un patient humain. Ces mesures 1 peuvent être réalisées notamment dans la région cardiaque ou thoracique, selon des séquences IRM choisies par le praticien en fonction des informations recherchées.

Ces mesures expérimentales s sont perturbées par des mouvements du patient, dus par exemple à sa respiration et/ou aux battements cardiaques.

Un objectif du procédé selon l'invention est de reconstruire une image IRM 6, notée $\rho_0$, qui correspond par exemple à une position physiologique moyenne du patient.

Le terme d'image désigne une collection de signaux d'imagerie IRM localisés spatialement, par exemple selon des grilles ou des matrices d'échantillonnage bidimensionnelles (2D) ou tridimensionnelles (3D).

Afin de permettre la reconstruction de l'image IRM $\rho_0$ à partir des mesures expérimentales s acquises par l'IRM, on définit un modèle de simulation 7 de la chaine d'acquisition, tel que :

$$s = E\rho_0 \ . \hspace{3cm} (\text{Eq. 1})$$

Le modèle de simulation de la chaîne d'acquisition est ainsi réalisé sous la forme d'un opérateur de simulation linéaire E qui lie une image $\rho_0$ de dimensions $N_x \times N_y \times N_z$ (le nombres de voxels dans les 3 dimensions spatiales) à des données expérimentales simulées s de dimensions $N_x \times N_y \times N_z \times N_\gamma \times N_R \times N_{NEX}$, $N_\gamma$ étant le nombre d'antennes, $N_R$ le facteur de réduction d'IRM parallèle, et $N_{NEX}$ le nombre d'excitations de l'acquisition expérimentale.

Les tailles typiques que l'on peut attendre pour les dimensions de l'opérateur linéaire E sont : $N_x \times N_y \times N_z$ = 256 × 256 × 32, $N_\gamma$ = 8, $N_R$ = 1 et $N_{NEX}$ = 4.

L'opérateur de simulation F peut être décomposé, ainsi que cela est décrit dans WO 2009/098371, en un ou plusieurs sous-éléments qui simulent chacun l'acquisition IRM 1 dans un groupe de positions physiologiques suffisamment proches pour ne pas perturber l'acquisition IRM. Typiquement le nombre de sous-éléments utilisés pour la réalisation du procédé selon l'invention est de huit. Les sous-éléments sont indexés par un indice t discret ($t = t_1, t_2, ... t_N$ ), qui représente le temps fictif d'acquisition d'un groupe de positions physiologiques suffisamment proches.

Le temps fictif t ne représente pas en général un instant matériel réalisé dans le mode réel mais plutôt un index de position physiologique considérée dans la simulation. Le fait qu'on introduit une quantification des données engendre un regroupement des données acquises à différents instants en paquets indexés par ces « index de position physiologique considérée » ou « temps virtuel ».

Les sous-éléments de l'opérateur de simulation E comprennent :

- un opérateur de transformation spatiale $T_t$ à un index $t$, qui est un opérateur d'interpolation représentant le déplacement de $t_0$ à t. L'opérateur $T_t$ est choisi de préférence comme une transformation spatiale arbitraire, permettant la prise en compte de déformations localement libres ;
- un opérateur de pondération en sensibilité d'antenne $\sigma_\gamma$ pour l'antenne correspondante $\gamma$ ($\gamma$ = 1 ...$N_\gamma$);
- un opérateur de transformée de Fourrier F en trois dimensions ; et
- un opérateur d'échantillonnage $\xi_t$ à un index t.

L'opérateur de simulation $E$ s'écrit alors en empilant les acquisitions des différentes antennes de la façon suivante :

$$E = \begin{bmatrix} \xi_{t_1} F \sigma_1 T_{t_1} \\ \vdots \\ \xi_{t_N} F \sigma_1 T_{t_N} \\ \hline \vdots \\ \hline \xi_{t_1} F \sigma_{N_\gamma} T_{t_1} \\ \vdots \\ \xi_{t_N} F \sigma_{N_\gamma} T_{t_N} \end{bmatrix}$$ (Eq. 2)

Les opérateurs de transformées spatiales $T_t$ sont déterminés à partir de modèles de perturbation par le mouvement, ou modèles de mouvement.

Les mouvements sont modélisés à partir de mesures représentatives de mouvements physiologiques 2 réalisées pendant les acquisitions IRM 1.

Les mesures de mouvement 2 peuvent être obtenues par différents moyens, en fonction des applications. On peut citer notamment :

- des mesures issues des acquisitions IRM, telles que des écho-navigateurs ;
- des mesures issues de capteurs externes, tel que par exemple des ceintures respiratoires et des électrodes d'électrocardiogramme, ou des signaux dérivés de ceux-ci.

On construit de préférence autant de modèles de mouvement ou modèles de mouvement partiels qu'il y a de mouvements physiologiques enregistrés. Par exemple, en disposant deux ceintures respiratoires sur le patient, on peut obtenir des informations correspondant respectivement au mouvement de la respiration thoracique et au mouvement de la respiration abdominale, qui permettent de générer deux modèles de mouvement.

On note $\alpha_i$ le paramètre ou l'ensemble de paramètres permettant de décrire un modèle de mouvement d'indice $i$, et on note $S_{i,t}$ les mesures de mouvements physiologiques 2 pour le modèle de mouvement d'indice i à l'instant t.

L'effet des modèles de perturbation par le mouvement peut être décrit par un champ de déplacement élastique $U_t$. Ce champ de déplacement, représentatif d'un modèle de mouvement global, est la combinaison linéaire des N modèles de mouvements physiologiques paramétrés par les paramètres $\alpha = \{\alpha_i\}_{i\in[1,N]}$. La pondération est donnée par les $N$ signaux physiologiques $S_{i,t}$ associés mesurés à l'instant t :

$$U_t = \sum_{i=1}^{N} \alpha_i S_{i,t}.$$ (Eq. 3)

Ainsi, pour chaque instant (fictif) t de l'acquisition, l'image $\rho_0$ peut être déformée en l'image $\rho_t$ - correspondant à la position physiologique à l'instant $t$ - à l'aide du champ de déplacement élastique $U_t$. Le modèle de mouvement global regroupant tous les modèles de mouvement est simplement appelé pour des raisons de clarté « le modèle de mouvement ».

Une étape importante du processus de reconstruction des signaux d'imagerie consiste donc à modéliser la chaine d'acquisition. Pour cela, il faut modéliser les mouvements physiologiques en déterminant leurs paramètres $\alpha = \{\alpha_i\}_{i\in[1,N]}$. De cette façon, il est ensuite possible de corriger les déplacements $U$ survenant lors de l'acquisition.

On parle donc de reconstruction adaptative car le processus de reconstruction de l'image utilise un modèle qui s'adapte à la chaine d'acquisition réelle de l'image, en prenant en compte les informations sur les mouvements :

$$E = E(\alpha).$$ (Eq. 5)

L'estimation 5 de l'image $\rho_0$ est réalisée par la résolution du problème inverse de l'équation (Eq. 1), plus particulièrement en utilisant la formulation du problème à symétrie hermitienne qui s'écrit de la façon suivante :

$$E^H s = E^H E \rho_0,$$ (Eq. 6)

Avec

$$E^H E = \sum_{n=1}^{N} T_{tn}^H \left( \sum_{\gamma=1}^{N_\gamma} \sigma_\gamma^H F^H \xi_{tn}^H \, \xi_{tn} F \sigma_\gamma \right) T_{tn}. \qquad \text{(Eq. 7)}$$

L'équation (Eq. 6) est résolue à l'aide d'un algorithme itératif qui ne nécessite pas la connaissance explicite de l'opérateur $E^H E$ tel que la méthode du gradient conjugué ou la méthode du résidu minimal généralisé (GMRES). De tels algorithmes ne nécessitent que la connaissance de la fonction $x \mapsto E^H Ex$ qui peut être calculée en appliquant les différents opérateurs dans la somme de l'équation (Eq. 7) en cascade. Ceci permet de limiter la demande en RAM dans l'implémentation et permet l'emploi de l'algorithme de transformée de Fourier rapide. Le conditionnement de l'opérateur $E^H E$ peut être augmenté en augmentant le nombre d'acquisitions indépendantes $N_{NEX}$. Une régularisation de Tikhonov est employée pour la résolution du problème inverse, l'opérateur $E^H E$ étant remplacé par $E^H E + \lambda \, Id$, $Id$ étant la matrice identité. Une valeur typique pour $\lambda$ est $\lambda = 0.01$. L'estimation de l'image $\rho_0$ peut être ainsi calculée au moyen de la formule suivante :

$$\rho_0 = \min_{\rho_0}\{\|s - E(\alpha)\rho_0\|^2 + \lambda\|\rho_0\|^2\}. \qquad \text{(Eq. 8)}$$

Comme le résultat de la reconstruction dépend de la qualité de la modélisation des paramètres $\alpha$ du mouvement, on peut supposer qu'il existe une relation linéaire au moins pour des petites variations entre l'erreur de reconstruction des données d'imagerie et l'erreur sur la modélisation du mouvement $\delta\alpha$.
Une estimation de l'erreur de reconstruction est obtenue en calculant des données expérimentales simulées $\hat{s}$ à partie de l'image $\rho_0$ avec le modèle de simulation 7 de la chaine d'acquisition. L'erreur de reconstruction est approximée par le résidu 9, noté $\varepsilon$, qui correspond à la différence 8 entre les données simulées $\hat{s}$ et les données expérimentales $s$,

$$\varepsilon = s - \hat{s} = s - E\rho_0 = R\delta\alpha \qquad \text{(Eq. 9)}$$

On introduit l'opérateur de résidu R pour définir la relation linéaire entre des petites variations des paramètres du modèle de perturbation de mouvement $\delta\alpha$ et le résidu $\varepsilon$, soit,

$$\varepsilon = R\delta\alpha. \qquad \text{(Eq. 10)}$$

Suivant un développement détaillé dans WO 2009/098371, l'opérateur de résidu $R(\rho_0, \alpha)$ peut s'écrire en fonction des opérateurs compris dans l'opérateur de simulation $E(\alpha)$, auxquels s'ajoute une composition du gradient spatial du signal d'imagerie estimé à l'instant considéré $(-\nabla\hat{\rho}_t)^T$ et des informations corrélées au mouvement $S_{i,t}$ :

$$\varepsilon = R(\rho_0, \alpha)\delta\alpha = \begin{bmatrix} \xi_{t_1} F \sigma_1 \left(-\nabla\hat{\rho}_{t_1}\right)^T \sum_{i=1}^{N} S_{i,t_1} \delta\alpha_i \\ \vdots \\ \xi_{t_N} F \sigma_1 \left(-\nabla\hat{\rho}_{t_N}\right)^T \sum_{i=1}^{N} S_{i,t_N} \delta\alpha_i \\ \hline \vdots \\ \xi_{t_1} F \sigma_{N_\gamma} \left(-\nabla\hat{\rho}_{t_1}\right)^T \sum_{i=1}^{N} S_{i,t_1} \delta\alpha_i \\ \vdots \\ \xi_{t_N} F \sigma_{N_\gamma} \left(-\nabla\hat{\rho}_{t_N}\right)^T \sum_{i=1}^{N} S_{i,t_N} \delta\alpha_i \end{bmatrix} \qquad \text{(Eq. 11)}$$

La résolvant du problème inverse de l'opérateur de résidu $R$, en prenant pour entrée le résidu $\varepsilon$ et fournissant en sortie les erreurs $\delta\alpha$ permet d'effectuer une optimisation 10 des paramètres du modèle de perturbation $\alpha$. Pour cela, on effectue une combinaison 11 (sous la forme d'une addition) des erreurs $\delta\alpha$ calculées avec les paramètres du modèle de perturbation initial 13, c'est-à-dire le modèle utilisé dans les étapes précédentes, et on obtient ainsi un modèle de perturbation optimisé 12 utilisable lors d'itérations suivantes.
De même que pour le problème inverse de la simulation 7, la résolution du problème inverse de l'opérateur de résidu R est effectuée en résolvant le problème à symétrie hermitienne équivalent en utilisant la méthode itérative GMRES.

La résolution du problème inverse de l'opérateur de résidu R en utilisant une régularisation explicite telle que décrite dans WO 2009/098371, pose un certain nombre de problèmes :

- Le nombre très important d'inconnues peut induire des difficultés de convergence de l'optimisation, et des problèmes de temps de calcul ;
- l'utilisation d'une régularisation explicite peut fausser la convergence de l'algorithme.

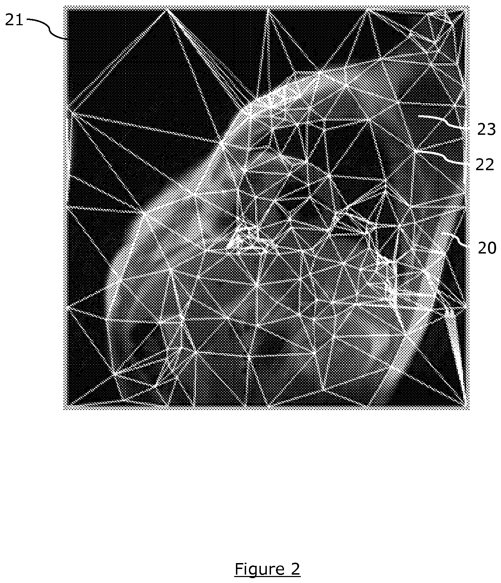

En référence à la figure 2, selon l'invention, la résolution du problème inverse de l'opérateur de résidu R est effectuée uniquement sur un sous-ensemble de points de la grille d'échantillonnage d'imagerie 21 sur laquelle sont reconstitués les signaux d'imagerie 20. Ce sous ensemble de points constitue la grille d'échantillonnage de mouvement 22. Cette grille est adaptée à la structure des organes et à la nature des mouvements du patient.

En effet, on a vu que par nature, certaines zones des modèles de déplacement sont lisses. Par exemple, deux éléments de tissus adjacents, auront un mouvement très corrélé s'ils appartiennent à la même structure. En revanche, deux éléments de tissus correspondant à l'interface entre deux structures peuvent avoir des déplacements indépendants. L'idée est donc d'utiliser peu de points pour décrire les zones où le mouvement est très corrélé et plus de points là où le mouvement est complexe. On constitue ainsi une grille irrégulière de points 22. De cette façon, on place chaque partie de l'objet sous les conditions les plus favorables pour l'évaluation du déplacement par une méthode d'optimisation.

Ainsi, on peut se contenter de calculer les paramètres $\alpha_{key}$ du modèle de mouvement 12 en résolvant le problème inverse de l'opérateur de résidu R uniquement sur les points de la grille d'échantillonnage de mouvement 22. Ensuite, le modèle de déplacement peut être retrouvé en n'importe quel point de la grille d'échantillonnage d'imagerie 21 l'aide d'une interpolation 14. En définissant une matrice d'interpolation $I_{key}$, cette interpolation 14 s'écrit :

$$\alpha = I_{key}\alpha_{key}. \qquad\qquad (\text{Eq. } 12)$$

De cette manière, on peut diminuer drastiquement le nombre d'inconnues du problème sans pour autant diminuer la qualité de la description du modèle de mouvement.

En outre, cette méthode peut être considérée comme un moyen de régularisation implicite. Il n'est plus nécessaire d'appliquer de contraintes directes (par le biais d'une régularisation explicite) sur la solution que l'on cherche. La contrainte est appliquée indirectement par la grille irrégulière : seules les zones présentant une faible densité de points induisent un lissage local du champ de déplacement. On a donc diminué le nombre de solutions possibles.

L'estimation 10 de l'erreur sur la modélisation du mouvement $\delta\alpha$ peut alors être ainsi calculée au moyen de la formule suivante :

$$\delta\alpha_{key} = \min_{\delta\alpha}\left\{\left\|\varepsilon - R(\rho_0, \alpha)I_{key}\delta\alpha_{key}\right\|^2\right\}. \qquad\qquad (\text{Eq. } 13)$$

On peut noter que cette formule ne contient pas de termes de régularisation explicite.

On va maintenant décrire les étapes de construction 4 de la grille d'échantillonnage de mouvement 22.

Lorsqu'on ne dispose pas d'estimation de l'image $p_o$ ni du modèle de mouvement $\alpha$, par exemple lors d'une première itération de l'algorithme, les points de la grille de mouvement ou grille irrégulière 22 sont sélectionnés aléatoirement. Un des avantages de la grille irrégulière 22 que l'on recherche, c'est le fait que le nombre de points en lesquels on devra trouver le modèle de mouvement est moins élevé que si on résolvait le problème sur la grille complète d'échantillonnage d'imagerie 21. Afin de conserver cette propriété sur la grille 22 sélectionnée aléatoirement, on ne sélectionne qu'un certain pourcentage du nombre de points 21 disponibles. Ce ratio peut être fixé au préalable par l'utilisateur. Par défaut, on prend un ratio de 1/25.

Lorsqu'on dispose d'une estimation de l'image $p_o$ et/ou du modèle de mouvement $\alpha$, on effectue les opérations suivantes pour sélectionner automatiquement les points de la grille de mouvement 22 :

- On construit pour les points de la grille d'échantillonnage d'imagerie 21 une carte de critères basée sur l'image $p_o$. La probabilité qu'un point de la grille 21 soit sélectionné pour la grille de mouvement 22 est fonction de la valeur de ce critère ;
- de même, on construit pour les points de la grille d'échantillonnage d'imagerie 21 une carte de critères basée sur le modèle de mouvement $\alpha$ ;
- on sélectionne les points sur la base de ces cartes de critères pour constituer la grille de mouvement 22.

On a vu qu'il est plus judicieux que les points de la grille irrégulière 22 se situent aux interfaces entre les organes. En effet, au sein d'un même tissu, on s'attend à ce que les déformations évoluent de façon linéaire, donc d'une façon qui peut être interpolée facilement à partir de peu de points. En revanche, les déformations sont susceptibles d'être plus complexes aux interfaces entre deux tissus distincts. On a donc besoin de plus de points pour les décrire. D'autre part, dans une image IRM (entre autres), au sein d'un même tissu le contraste de l'image varie peu, donc même si un mouvement survient dans le tissu, il aura peu de conséquences sur l'image $p_o$. Il n'est donc pas nécessaire de le décrire précisément.

Afin de détecter les interfaces entre les organes, on utilise un critère basé sur la norme du gradient de l'image $\rho_o$.

On classe les points 21 par ordre décroissant à partir de ce critère.

C'est aux endroits où le mouvement est le plus complexe, c'est-à-dire là où il varie le plus, que le nombre de points sélectionnés 22 doit être le plus important. Donc de manière analogue, le critère choisi est le gradient du modèle de mouvement, représentatif du déplacement $U_t$. On calcule les valeurs des gradients dans les différentes directions de l'image. Par exemple en 2D, on a deux gradients, dans la direction X et Y.

A partir de cette carte de gradient du modèle de mouvement, on construit une carte de dispersion pour chaque dimension de la grille d'échantillonnage d'imagerie 21 (soit deux cartes si on est en 2D), en associant à chaque point un coefficient de dispersion par dimension.

Les coefficients de dispersion sont définis entre une valeur de dispersion minimale une valeur de dispersion maximale. Ces valeurs peuvent être fixées au préalable par l'utilisateur. Par défaut, la dispersion minimale est de 1 pixel/voxel et la dispersion maximale est de 1/5 de la taille de l'image dans la direction d'intérêt.

Les coefficients de dispersion sont définis selon une fonction inversement proportionnelle au gradient du modèle de mouvement : les points ayant le plus petit gradient (qui correspondent donc à des zones se déformant peu localement) se voient attribuer un coefficient de dispersion maximal et inversement. On associe ainsi une dispersion à chaque point en fonction de son gradient, et ce dans toutes les directions.

À partir de la liste des points 21 classés en fonction du critère basé sur la norme du gradient de l'image $p_o$ et des cartes de dispersion, on sélectionne les points les plus adaptés pour construire la grille de mouvement 22. La procédure est la suivante :

1) on crée une carte des points sectionnés (vide pour le moment) ;
2) on détermine par seuillage un seuil qui décrit le fond « noir » de l'image $p_o$ (c'est-à-dire n'appartenant pas au milieu biologique) ;
3) on parcourt la liste classée des points en fonction du critère basé sur la norme du gradient de l'image $p_o$. Pour chaque point qui n'appartient pas au au fond de l'image :

- on construit une zone de sécurité rectangulaire autour du point, dont les dimensions sont données par les cartes de dispersions calculées précédemment dans les différentes directions. Les dimensions de la zone de sécurité peuvent être en particulier proportionnelles ou égales aux coefficients de dispersion au point ;
- si cette zone de sécurité ne comprend pas de points déjà sélectionnés, on ajoute ce point à la carte des points sélectionnés. Sinon on ne l'ajoute pas ;
- on répète ces étapes jusqu'à avoir sélectionné le nombre de points maximal choisi par l'utilisateur (avec une valeur par défaut de 1/25 du nombre de points total 21) ou jusqu'à avoir parcouru toute la liste.

Ainsi, les points sélectionnés, qui définissent la grille de mouvement 22 se situent en priorité aux interfaces entre les organes, et sont plus denses là où le mouvement est complexe. De cette façon, la grille 22 est optimale pour pouvoir se permettre de restreindre la description du mouvement qu'en ces points.

Comme indiqué précédemment, l'algorithme selon l'invention reconstruit autant de modèles de mouvement $\alpha_i$ qu'il y a de mouvements physiologiques enregistrés $S_{i,t}$. Les déplacements induits sur les organes par chacun de ces mouvements physiologiques sont différents. Il est donc construit autant de grilles irrégulières 22 qu'il y a de mouvements physiologiques $S_{i,t}$.

Cela signifie que pour $i$ mouvements physiologiques, on construit $i$ grilles de mouvement avec chacune sa matrice d'interpolation $I_{key,i}$ et on effectue les étapes d'optimisation 10 et de calcul du modèle optimisé 12 pour chacune de ces grilles de telle sorte à mettre à jours les paramètres $\alpha_{key,i}$ sur leurs grilles 22 respectives.

Dans ce cas, l'optimisation couplée du modèle de simulation 5 pour obtenir l'image $\rho_0$ et des modèles de mouvement 10 pour obtenir les paramètres $\alpha_{key,i}$ respectifs est réalisée par une méthode de point fixe, c'est-à-dire que chaque modèle est optimisé séparément, tous les autres étant considérés fixés. Cette optimisation est réalisée de manière alternée sur le modèle de simulation 5 puis sur l'un des modèles de mouvement 10, cette séquence d'optimisation étant répétée alternativement sur chacun des modèles.

Le calcul de la matrice d'interpolation $I_{key}$ qui permet de déterminer les paramètres de mouvement $\alpha$ en tous points de la grille d'échantillonnage d'imagerie 21 à partie des paramètres $\alpha_{key}$ calculés sur la grille de mouvement 22 comprend deux étapes :

- On effectue tout d'abord une triangulation de Delaunay sur l'ensemble des points de la grille de mouvement 22, de telle sorte que chaque point de la grille d'échantillonnage d'imagerie 21 (qui n'est pas en même temps un point de la grille de mouvement 22) soit inclus dans un seul unique triangle dont les sommets sont des points de la grille de mouvement 22.
- Ensuite, pour chaque point P de la grille d'échantillonnage d'imagerie 21, on cherche à quel triangle il appartient. On note $Q_k$ les points de la grille de mouvement 22 qui en sont les sommets. On cherche les poids $w_k$ à associer à chaque sommet $Q_k$ de façon à ce que la somme des poids $w_k$ soit unitaire et que le point P soit le barycentre des sommets $Q_k$ pondérés avec les poids $w_k$ (en 2D, cette opération correspond à l'inversion d'un système linéaire 2x2). Ces poids correspondent à la contribution qu'il faut donner à chaque valeur du modèle de mouvement aux points $Q_k$ de la grille de mouvement 22 pour retrouver le déplacement au point P. Donc :

$$I_{key}(P, Q_k) = w_k \qquad \text{(Eq. 14)}$$

On notera que la matrice d'interpolation $I_{key}$ est indépendante des valeurs du modèle de mouvement $\alpha_{key}$ sur la grille 22. Elle dépend uniquement de la position des points de la grille de mouvement 22. Il suffit donc de calculer une seule fois une matrice d'interpolation $I_{key}$ par grille de mouvement 22.

Cette méthode de calcul de la matrice d'interpolation $I_{key}$ est valable en n'importe quelle dimension. Elle est notamment applicable en 3D, en utilisant des tétraèdres au lieu de triangles pour réaliser la triangulation.

En référence à la figure 2, le procédé selon l'invention est mis en oeuvre de manière itérative dans une approche multirésolution.

Le procédé selon l'invention est basé sur la résolution de deux systèmes linéaires 5, 10 couplés. Ce sont des algorithmes d'optimisation itératifs qui sont utilisés pour résoudre alternativement ces deux équations dans le cadre de la méthode du point fixe. De façon générale, les algorithmes d'optimisation itératifs nécessitent une bonne initialisation de la solution. Plus l'initialisation est éloignée de la solution, plus la convergence va être longue et plus on risque de converger vers un minimum local ne correspondant pas à la solution. D'autre part, plus le nombre d'inconnues de l'équation est élevé, plus ces écueils sont importants.

L'idée des boucles multi-résolutions consiste donc à résoudre le problème en premier lieu à basse résolution spatiale, c'est-à-dire avec une grille d'échantillonnage d'imagerie 21 de peu de points et de faible résolution spatiale. Ainsi, le nombre d'inconnues est faible et la convergence est assurée, même avec une initialisation quelconque. Ensuite, on peut se servir des solutions basse résolution que l'on vient d'obtenir pour initialiser le problème à une résolution plus élevée, puis résoudre le problème une nouvelle fois à la nouvelle résolution. Et ainsi de suite jusqu'au niveau de résolution natif.

Le procédé comprend deux boucles d'itération imbriquées : une boucle de résolution 31 et une boucle d'optimisation (à une résolution donnée) 33.

La condition d'arrêt 39 de la boucle de résolution est l'atteinte de la résolution maximale. On obtient ainsi le résultat 40, à savoir l'image $\rho_0$ et le modèle $\alpha$.

La boucle de résolution comprend une étape 32 de calcul de la grille de mouvement 22, et de détermination de la matrice d'interpolation $I_{key}$ et des paramètres des modèles de mouvement $\alpha_{key}$. Les données d'entrées comprennent soit des paramètres de mouvement nuls ($\alpha = 0$) lors de la première itération, soit les paramètres de mouvement $\alpha$ et l'image $\rho_0$ obtenus à l'issu de l'itération à la résolution inférieure.

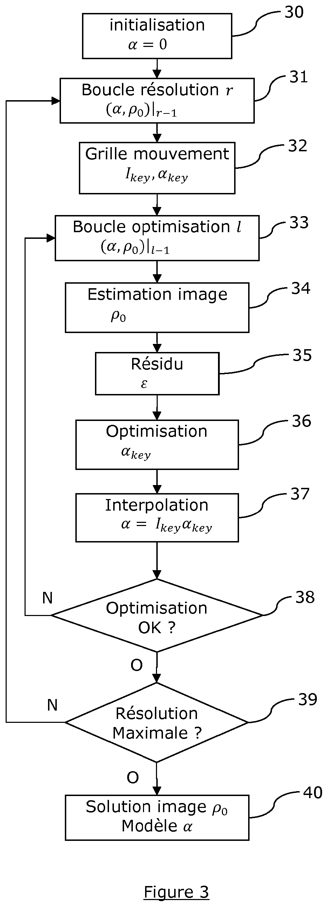

On entre ensuite dans la boucle d'optimisation 33, qui comprend les étapes, détaillées à la figure 3 :

- d'estimation 34 de l'image $\rho_0$,
- de calcul 35 du résidu $\varepsilon$,
- d'optimisation 36 des paramètres du modèle de mouvement $\alpha_{key}$ sur la ou les grille(s) de mouvement 22,
- de calcul par interpolation 37 des paramètres du modèle de mouvement $\alpha$ sur la grille d'échantillonnage d'imagerie 21.

A chaque itération de la boucle d'optimisation, les estimations de l'image $\rho_0$ et des paramètres de mouvement $\alpha$, $\alpha_{key}$ obtenus lors de l'itération précédente sont utilisées pour calculer de nouvelles estimations, jusqu'à atteindre une condition d'arrêt 38 basée sur une détection d'une convergence vers une estimation optimale de ces paramètres.

Suivant des variantes :

- Lors d'une première itération où on ne dispose pas encore d'estimation de l'image $\rho_o$ ni du modèle de mouvement $\alpha$, les points de la grille de mouvement 22 peuvent être sélectionnés en effectuant un sous-échantillonnage systématique de la grille d'échantillonnage d'imagerie 21 ;
- Les points de la grille de mouvement 22 peuvent être sélectionnés dans le plan ou le volume couvert par la grille d'échantillonnage d'imagerie 21, mais au moins pour une partie d'entre eux, ne pas être compris dans les points de la grille d'échantillonnage d'imagerie 21 ;

- La grille d'échantillonnage de mouvement irrégulière peut être appliquée à de l'imagerie 2D, ou 3D. Le procédé est particulièrement avantageux pour de l'imagerie 3D en raison du nombre plus important d'inconnues à traiter ;
- Il peut n'être utilisé qu'une seule grille de mouvement 22 pour une pluralité ou tout les mouvements physiologiques $S_{i,t}$ ;
- Lors de la construction de la grille d'échantillonnage de mouvement irrégulière, plutôt que de sélectionner directement un point « candidat » de la liste des points 21 classés, il est possible de déterminer l'orientation du contour de l'image en ce point et de placer deux points de chaque côté du contour, autour du point « candidat » initialement identifié. Par exemple, dans le cas d'une image comprenant une interface séparant deux parties, avec la méthode décrite dans le mode de réalisation principal les points de la grille d'échantillonnage de mouvement sont tous alignés sur cette interface. Dans la présente variante, les points de la grille d'échantillonnage de mouvement sont répartis de chaque côté de l'interface, à proximité immédiate de cette dernière. Ainsi, un mouvement de cisaillement au niveau de cette interface est mieux décrit ;
- Des critères de sélection des points peuvent être ajoutés pour construire la ou les grilles de mouvement 22. On peut notamment ajouter comme critère de sélection des points que le gradient de l'image $\rho_o$ au point doit également présenter un maximum local. Cette contrainte supplémentaire peut être nécessaire par exemple pour des images avec peu de variations de niveaux (images lisses) ;
- D'autres critères peuvent être utilisés pour construire la ou les grilles de mouvement 22, et éventuellement des critères différents pour des grilles différentes. Pour le critère sur l'image $\rho_0$, on peut utiliser une reconnaissance de formes pour distinguer les organes entre eux. On peut aussi utiliser un jeu de données parfaitement connu sur lequel un expert détermine au préalable les meilleurs emplacements des points, puis utiliser ces grilles de référence 22 comme un « atlas » pour les adapter par un recalage à notre cas particulier ;
- Dans une approche multi-résolution telle que présentée à la figure 3, on peut n'utiliser les grilles irrégulières 22 qu'à partir d'un certain niveau de résolution, lorsque la méthode de multi-résolution ne suffit plus à permettre la convergence de l'algorithme ;
- Au cours d'un même niveau de résolution, l'estimation de l'image $\rho_0$ et l'estimation du modèle de mouvement a s'améliorent. Il est possible de ré-exécuter l'algorithme 4 de détermination des grilles de mouvement 22 à chaque fois que ces inconnues $\rho_0$, $\alpha$ sont améliorées ;
- Le principe de la grille d'échantillonnage irrégulière peut être appliqué à n'importe quel élément de solution du problème. Dans les modes de réalisation présentés, on reconstruit une image et au moins un modèle de mouvement pour lequel on utiliser la grille irrégulière. Il est également possible d'ajouter l'optimisation de cartes de sensibilité d'antenne ou encore de signaux physiologiques. Dans ce cas, des grilles irrégulières peuvent être utilisées sur ces éléments ;
- Le principe de l'utilisation de la grille irrégulière pour la description d'un modèle de mouvement peut s'inscrire dans un cadre beaucoup plus large et notamment être utilisé dans tous les problèmes de recalage non rigide.

Bien sûr, l'invention n'est pas limitée aux exemples qui viennent d'être décrits et de nombreux aménagements peuvent être apportés à ces exemples sans sortir du cadre de l'invention.

**Revendications**

1. Procédé de reconstruction de signaux d'imagerie médicale (6, 40) en milieu biologique à partir de mesures expérimentales (1) acquises par un système d'imagerie médicale perturbées par des mouvements physiologiques, le procédé mettant en oeuvre :

   - des mesures représentatives desdits mouvements physiologiques (2),
   - au moins un modèle de mouvement comprenant des paramètres de mouvement $\alpha$ (13, 14) aptes à décrire des mouvements et/ou des déformations du milieu biologique à partir desdites mesures représentatives de mouvements physiologiques (2), et
   - une grille d'échantillonnage d'imagerie (21) selon laquelle la reconstruction de signaux d'imagerie est réalisée,

   le procédé étant **caractérisé en ce qu'**il comprend en outre la mise en oeuvre d'une boucle (31) itérative comportant :

   - construction (4) d'une grille sélectionnée d'échantillonnage de mouvement (22, 32) par sélection d'un ensemble restreint de points à partir de la grille d'échantillonnage d'imagerie (21), les points sélectionnés pour construire la grille sélectionnée d'échantillonnage de mouvement (22, 32) étant choisis en fonction des paramètres de mouvement issus d'une estimation préalable dudit au moins un modèle de mouvement, de sorte que les points de la grille d'échantillonnage de mouvement sont à proximité des zones du milieu biologique affectées par des variations de mouvements dans les différentes directions de l'image et/ou des déformations locales comparativement plus importantes ; et

- calcul itératif (33) comprenant la mise en oeuvre de manière alternée des étapes suivantes:

• calcul des paramètres de mouvement (12, 36) de chaque modèle de mouvement par inversion d'un système linéaire (10) aux points de ladite grille sélectionnée d'échantillonnage de mouvement (22) construite, en utilisant un modèle de simulation d'une chaîne d'acquisition de l'image (7), la chaine d'acquisition étant sous la forme d'un opérateur de simulation linéaire $E(\alpha)$ qui lie une image à des données expérimentales simulées,

• estimation d'une erreur de reconstruction (8) en calculant des données expérimentales simulées à partir de l'image préalablement estimée (5, 34) avec le modèle de simulation de la chaine d'acquisition et les paramètres de mouvement calculés,

• calcul d'une erreur sur les paramètres de mouvement par inversion, aux points de ladite grille sélectionnée d'échantillonnage de mouvement (22), d'un système linéaire définissant une relation linéaire entre des petites variations des paramètres du modèle de mouvement et un résidu $\varepsilon$ représentatif de l'erreur de reconstruction estimée (9, 35);

• estimation du modèle de mouvement par optimisation (10) des paramètres du modèle de mouvement à partir de l'erreur calculée.

2. Le procédé selon la revendication 1, dans lequel les points sélectionnés pour construire la grille sélectionnée d'échantillonnage de mouvement (22, 32) sont en outre choisis en fonction du critère suivant : leur proximité avec des zones d'interfaces entre des structures ou organes du milieu biologique.

3. Le procédé selon la revendication 2, dans lequel la construction de la grille sélectionnée d'échantillonnage de mouvement (22, 32) comprend en outre des étapes de :

- classification des points de la grille d'échantillonnage d'imagerie (21) du milieu biologique (20) préalablement obtenue selon un critère de proximité représentatif de leur proximité avec des zones d'interfaces entre des structures ou organes du milieu biologique, de telle sorte à en constituer une liste,

- définition de zones de sécurité autour des points de la grille d'échantillonnage d'imagerie (21), dont l'étendue est une fonction inverse de la variation du mouvement calculé avec au moins un modèle de mouvement, et

- constitution de la grille sélectionnée d'échantillonnage de mouvement (22) en parcourant la liste des points classifiés à partir des points les plus proches des zones d'interfaces entre des structures ou organes du milieu biologique, et en ne conservant en vue de la construction de la grille sélectionnée d'échantillonnage de mouvement (22) que les points pour lesquels aucun point appartenant déjà à la grille sélectionnée d'échantillonnage de mouvement (22) ne se trouve dans leur zone de sécurité.

4. Le procédé selon la revendication 3, dans lequel la valeur du critère de proximité est basée sur la norme du gradient de l'image au point considéré.

5. Le procédé selon l'une des revendications 3 ou 4, dans lequel l'étendue de la zone de sécurité selon les axes de la grille est une fonction inverse du gradient du mouvement selon lesdits axes respectifs.

6. Le procédé selon l'une quelconque des revendications précédentes, qui comprend en outre une étape (14, 37) de détermination des paramètres de mouvement aux points de la grille d'échantillonnage d'imagerie par interpolation des valeurs calculées aux points de la grille d'échantillonnage de mouvement.

7. Le procédé selon la revendication 6, qui comprend en outre une étape (14, 37) de calcul d'une matrice d'interpolation faisant le lien entre les paramètres de chaque modèle de mouvement (12) aux points de la grille sélectionnée d'échantillonnage de mouvement (22) et aux points de la grille d'échantillonnage d'imagerie (21), lequel calcul de matrice d'interpolation comprenant des étapes :

- de réalisation d'une triangulation de Delaunay entre les points de la grille sélectionnée d'échantillonnage de mouvement (22), de telle sorte que les points de la grille sélectionnée d'échantillonnage d'imagerie (21) n'appartenant pas à la grille sélectionnée d'échantillonnage de mouvement (22) soient inclus respectivement dans un seul triangle dans le cas d'une image 2D, ou un seul tétraèdre dans le cas d'une image 3D, dont les sommets sont des points de la grille sélectionnée d'échantillonnage de mouvement (22),

- de calcul, pour chaque point considéré de la grille d'échantillonnage d'imagerie (21), de coefficients de pondération barycentriques relatifs aux sommets du triangle ou du tétraèdre incluant ledit point, définissant la position dudit point relativement auxdits sommets.

8. Le procédé selon l'une quelconque des revendications précédentes, qui met en oeuvre des mesures représentatives d'une pluralité de mouvements physiologiques (2), et une pluralité de modèles de mouvement associés auxdits mouvements physiologiques, et qui comprend des étapes de construction (4, 32) d'une pluralité de grilles sélectionnées d'échantillonnage de mouvement (22) pour les différents mouvements physiologiques, et de calcul de paramètres respectifs de mouvement (12, 36) selon lesdites grilles sélectionnées (22).

9. Le procédé selon l'une quelconque des revendications précédentes, dans lequel la reconstruction des signaux d'imagerie (6) comprend une étape (5, 34) d'inversion d'un système linéaire décrivant une relation entre les mesures expérimentales (1) et les images (6, 20), et prenant en compte des paramètres de mouvement (14, 33) préalablement déterminés aux points de la grille d'échantillonnage d'imagerie (21).

10. Le procédé selon la revendication 9, dans lequel le calcul des paramètres de mouvement (14, 33) aux points de la grille sélectionnée d'échantillonnage de mouvement (22) comprend une étape d'inversion (10, 36) d'un système linéaire décrivant une relation entre, d'une part, une erreur (9, 35) entre des mesures expérimentales (1) et des mesures estimées à partir de signaux d'imagerie reconstruit, et d'autre part d'erreurs sur les paramètres de mouvement préalablement calculés (13).

11. Le procédé selon la revendication 10, dans lequel l'inversion (10, 36) du système linéaire décrivant une relation entre les erreurs de mesure (9, 35) et les erreurs sur les paramètres de mouvement est effectuée sans régularisation explicite.

12. Le procédé selon l'une quelconque des revendications précédentes, qui comprend en outre une répétition itérative (31) des étapes de construction d'une grille sélectionnée d'échantillonnage permettant la construction (5, 34) des signaux d'imagerie (6) et de calcul (10, 11, 36) de paramètres de mouvement, pour des grilles d'échantillonnage d'imagerie (21) de résolutions spatiales croissantes.

13. Le procédé selon la revendication 1, **caractérisé en ce qu'**il comprend également une répétition itérative de l'étape de construction d'une grille sélectionnée d'échantillonnage de mouvement et une répétition itérative de l'étape de calcul des paramètres de mouvement de chaque modèle de mouvement, dans lequel, pour une itération donnée de l'étape de construction d'une grille sélectionnée d'échantillonnage de mouvement, les points sélectionnés pour construire ladite grille sélectionnée d'échantillonnage de mouvement sont choisis en utilisant un critère construit en fonction des paramètres de mouvement de chaque modèle de mouvement calculé dans l'itération précédente de l'étape de calcul des paramètres de mouvement de chaque modèle de mouvement.

14. Le procédé selon l'une quelconque des revendications précédentes, pour la reconstruction de signaux d'imagerie (6, 40) sous une forme choisie parmi un voxel, une image, une série d'images, un volume IRM, et une série de volumes IRM.

15. Le procédé selon l'une quelconque des revendications 1 à 13, pour la reconstruction de signaux d'imagerie (6, 40) sous la forme d'au moins un spectre d'au moins un voxel de spectroscopie par RMN.

16. Le procédé selon l'une quelconque des revendications 1 à 13, pour la reconstruction de signaux d'imagerie (6, 40) sous une forme choisie parmi un voxel, une image, une série d'images, un volume et une série de volumes, issu d'au moins un processus d'acquisition d'images médicales parmi l'IRM, la tomographie par rayons X, la Tomographie par Emission de Positons, la tomographie d'émission monophotonique et l'échographie.

17. Dispositif comprenant des moyens d'imagerie médicale et mettant en oeuvre le procédé de reconstruction de signaux d'imagerie selon l'une quelconque des revendications précédentes.

18. Un dispositif selon la revendication 17, comprenant des moyens d'imagerie IRM et mettant en oeuvre le procédé selon l'une quelconque des revendications 1 à 13.

19. Un dispositif selon la revendication 17, comprenant des moyens d'imagerie spectroscopique par RMN et mettant en oeuvre le procédé selon l'une quelconque des revendications 1 à 11 et 14.

**Patentansprüche**

1. Verfahren zur Rekonstruktion von Bildsignalen (6, 40) zur medizinischen Bildgebung aus einem biologischen Medium anhand von durch physiologische Bewegungen gestörten experimentellen Messungen (1), die von einem medizinischen Bildgebungssystem erfasst werden, wobei das Verfahren implementiert:

   - Messungen, die für die physiologischen Bewegungen (2) repräsentativ sind,
   - zumindest ein Bewegungsmuster mit Bewegungsparametern $\alpha$ (13, 14), die geeignet sind, Bewegungen und/oder Verformungen des biologischen Mediums anhand der für die physiologischen Bewegungen (2) repräsentativen Messungen zu beschreiben, und
   - ein Bildgebungsabtastgitter (21), wonach die Rekonstruktion von Bildsignalen erfolgt,

   wobei das Verfahren **dadurch gekennzeichnet ist, dass** es ferner die Implementierung einer Iterationsschleife (31) umfasst, die die folgenden Schritte umfasst:

   - Aufbauen (4) eines ausgewählten Bewegungsabtastgitters (22, 32) durch Auswahl einer begrenzten Punktmenge aus dem Bildgebungsabtastgitter (21), wobei die ausgewählten Punkte zum Aufbauen des ausgewählten Bewegungsabtastgitters (22, 32) in Abhängigkeit von Bewegungsparametern ausgewählt werden, die aus einer vorherigen Schätzung des zumindest einen Bewegungsmusters stammen, so dass die Punkte des Bewegungsabtastgitters in der Nähe derjenigen Bereiche des biologischen Mediums liegen, die von vergleichsweise größeren Bewegungsänderungen in verschiedenen Bildrichtungen und/oder lokalen Verformungen betroffen sind; und

      - iterative Berechnung (33), die die wechselweise Ausführung der folgenden Schritte umfasst:

         • Berechnen der Bewegungsparameter (12, 36) jedes Bewegungsmusters durch Inversion eines linearen Systems (10) an den Punkten des ausgewählten, aufgebauten Bewegungsabtastgitters (22) unter Verwendung eines Simulationsmodells einer Bilderfassungskette (7), wobei die Erfassungskette in Form eines linearen Simulationsoperators E ($\alpha$) vorliegt, der ein Bild mit simulierten experimentellen Daten verknüpft,
         • Schätzen eines Rekonstruktionsfehlers (8) durch Berechnen von simulierten experimentellen Daten aus dem zuvor geschätzten Bild (5, 34) mit dem Simulationsmodell der Erfassungskette und den berechneten Bewegungsparametern,
         • Berechnen eines Fehlers bei den Bewegungsparametern durch Inversion eines linearen Systems an den Punkten des ausgewählten Bewegungsabtastgitters (22), wobei das System eine lineare Beziehung zwischen kleineren Abweichungen der Parameter des Bewegungsmusters und einem Residuum $\varepsilon$ definiert, das für den geschätzten Rekonstruktionsfehler (9, 35) repräsentativ ist;
         • Schätzen des Bewegungsmusters durch Optimierung (10) der Parameter des Bewegungsmusters anhand des berechneten Fehlers.

2. Verfahren nach Anspruch 1, wobei die zum Aufbauen des ausgewählten Bewegungsabtastgitters (22, 32) ausgewählten Punkte zusätzlich nach dem folgenden Kriterium ausgewählt werden: ihrer Nähe zu Schnittstellenbereichen zwischen Strukturen oder Organen des biologischen Mediums.

3. Verfahren nach Anspruch 2, wobei das Aufbauen des ausgewählten Bewegungsabtastgitters (22, 32) ferner folgende Schritte umfasst:

   - Klassifizieren der Punkte des zuvor erhaltenen Bildgebungsabtastgitters (21) des biologischen Mediums (20) nach einem Kriterium der Nähe, das für ihre Nähe zu Schnittstellenbereichen zwischen Strukturen oder Organen des biologischen Mediums repräsentativ ist, so dass daraus eine Liste erstellt wird,
   - Festlegen von Sicherheitsbereichen um die Punkte des Bildgebungsabtastgitters (21), deren Ausdehnung eine inverse Funktion der Abweichung der mit zumindest einem Bewegungsmuster berechneten Bewegung ist, und
   - Aufbauen des ausgewählten Bewegungsabtastgitters (22) durch Durchlaufen der Liste der klassifizierten Punkte ausgehend von denjenigen Punkten, die den Schnittstellenbereichen zwischen Strukturen oder Organen des biologischen Mediums am nächsten liegen, und durch Beibehalten nur derjenigen Punkte für das Aufbauen des ausgewählten Bewegungsabtastgitters (22), für die kein Punkt, der bereits zu dem ausgewählten Bewegungsabtastgitters (22) gehört, innerhalb ihres Sicherheitsbereichs liegt.

**4.** Verfahren nach Anspruch 3, wobei das Maß des Kriteriums für die Nähe auf dem Betrag des Bildgradienten an dem betreffenden Punkt basiert.

**5.** Verfahren nach einem der Ansprüche 3 oder 4, wobei die Ausdehnung des Sicherheitsbereichs entlang der Gitterachsen eine inverse Funktion des Gradienten der Bewegung entlang der jeweiligen Achsen ist.

**6.** Verfahren nach einem der vorhergehenden Ansprüche, ferner umfassend einen Schritt (14, 37) des Bestimmens der Bewegungsparameter an den Punkten des Bildgebungsabtastgitters durch Interpolation der berechneten Werte an den Punkten des Bewegungsabtastgitters.

**7.** Verfahren nach Anspruch 6, ferner umfassend einen Schritt (14, 37) des Berechnens einer Interpolationsmatrix, die die Parameter jedes Bewegungsmusters (12) an den Punkten des ausgewählten Bewegungsabtastgitters (22) und an den Punkten des Bildgebungsabtastgitters (21) verknüpft, wobei das Berechnen der Interpolationsmatrix die folgenden Schritte umfasst:

- Durchführen einer Delaunay-Triangulierung zwischen den Punkten des ausgewählten Bewegungsabtastgitters (22), so dass diejenigen Punkte des ausgewählten Bildgebungsabtastgitters (21), die nicht zum ausgewählten Bewegungsabtastgitter (22) gehören, jeweils in einem einzigen Dreieck im Fall eines 2D-Bildes oder einem einzigen Tetraeder im Fall eines 3D-Bildes enthalten sind, deren Eckpunkte Punkte des ausgewählten Bewegungsabtastgitters (22) sind,
- Berechnen von baryzentrischen Gewichtungskoeffizienten für jeden betrachteten Punkt des Bildgebungsabtastgitters (21), die sich auf die Eckpunkte des den Punkt enthaltenden Dreiecks oder Tetraeders beziehen und die Position des Punktes relativ zu den Eckpunkten definieren.

**8.** Verfahren nach einem der vorhergehenden Ansprüche, wobei Messungen, die für eine Vielzahl von physiologischen Bewegungen (2) repräsentativ sind, und eine Vielzahl von Bewegungsmustern, die den physiologischen Bewegungen zugeordnet sind, implementiert werden, und das die Schritte des Aufbauens (4, 32) einer Vielzahl von ausgewählten Bewegungsabtastgittern (22) für die verschiedenen physiologischen Bewegungen und des Berechnens jeweiliger Bewegungsparameter (12, 36) gemäß den ausgewählten Gittern (22) umfasst.

**9.** Verfahren nach einem der vorhergehenden Ansprüche, wobei die Rekonstruktion der Bildsignale (6) einen Schritt (5, 34) der Inversion eines linearen Systems umfasst, das eine Beziehung zwischen den experimentellen Messungen (1) und den Bildern (6, 20) beschreibt und Bewegungsparameter (14, 33) berücksichtigt, die zuvor an den Punkten des Bildgebungsabtastgitters (21) bestimmt wurden.

**10.** Verfahren nach Anspruch 9, wobei das Berechnen der Bewegungsparameter (14, 33) an den Punkten des ausgewählten Bewegungsabtastgitters (22) einen Schritt der Inversion (10, 36) eines linearen Systems umfasst, das eine Beziehung zwischen einerseits einem Fehler (9, 35) zwischen experimentellen Messungen (1) und aus rekonstruierten Bildsignalen geschätzten Messungen und andererseits Fehlern bei den zuvor berechneten Bewegungsparametern (13) beschreibt.

**11.** Verfahren nach Anspruch 10, wobei die Inversion (10, 36) des linearen Systems, das eine Beziehung zwischen den Messfehlern (9, 35) und den Fehlern bei den Bewegungsparametern beschreibt, ohne explizite Regularisierung erfolgt.

**12.** Verfahren nach einem der vorhergehenden Ansprüche, ferner umfassend eine iterative Wiederholung (31) der Schritte des Aufbauens eines ausgewählten Abtastgitters für die Konstruktion (5, 34) der Bildsignale (6) und des Berechnens (10, 11, 36) von Bewegungsparametern für Bildgebungsabtastgitter (21) mit zunehmender räumlicher Auflösung.

**13.** Verfahren nach Anspruch 1, **dadurch gekennzeichnet, dass** es auch eine iterative Wiederholung des Schritts des Aufbauens eines ausgewählten Bewegungsabtastgitters und eine iterative Wiederholung des Schritts des Berechnens von Bewegungsparametern für jedes Bewegungsmuster umfasst, wobei für eine gegebene Iteration des Schritts des Aufbauens eines ausgewählten Bewegungsabtastgitters, die zum Aufbauen des ausgewählten Bewegungsabtastgitters ausgewählten Punkte unter Anwendung eines Kriteriums ausgewählt werden, das auf der Grundlage der Bewegungsparameter des jeweiligen Bewegungsmusters erstellt wird, das bei der vorherigen Iteration des Schritts des Berechnens der Bewegungsparameter des jeweiligen Bewegungsmusters berechnet wurde.

**14.** Verfahren nach einem der vorhergehenden Ansprüche zur Rekonstruktion von Bildsignalen (6, 40) in einer Form, die aus einem Voxel, einem Bild, einer Reihe von Bildern, einem MRT-Volumen und einer Reihe von MRT-Volumen ausgewählt ist.

**15.** Verfahren nach einem der Ansprüche 1 bis 13 zur Rekonstruktion von Bildsignalen (6, 40) in Form von zumindest einem Spektrum aus zumindest einem Voxel in der NMR-Spektroskopie.

**16.** Verfahren nach einem der Ansprüche 1 bis 13 zur Rekonstruktion von Bildsignalen (6, 40) in einer Form, die aus einem Voxel, einem Bild, einer Reihe von Bildern, einem Volumen und einer Reihe von Volumen ausgewählt ist, die aus zumindest einem medizinischen Bildaufnahmeverfahren aus MRT, Röntgen-Tomographie, Positronen-Emissions-Tomographie, Einzelphotonen-Emissions-Tomographie und Sonographie stammen.

**17.** Vorrichtung mit Mitteln für die medizinische Bildgebung zum Durchführen des Verfahrens zur Rekonstruktion von Bildsignalen nach einem der vorhergehenden Ansprüche.

**18.** Vorrichtung nach Anspruch 17 mit Mitteln für die MRT-Bildgebung zum Durchführen des Verfahrens nach einem der Ansprüche 1 bis 13.

**19.** Vorrichtung nach Anspruch 17 mit Mitteln für die Bildgebung bei der NMR-Spektroskopie zum Durchführen des Verfahrens nach einem der Ansprüche 1 bis 11 und 14.


**Claims**

**1.** Method for reconstructing imaging signals (6, 40) in a biological medium on the basis of experimental measurements (1) acquired by a medical imaging system perturbed by physiological movements, the method implementing:

- measurements representative of said physiological movements (2),
- at least one movement model comprising movement parameters $\alpha$ (13, 14) capable of describing movements and/or deformations of the biological medium on the basis of said measurements representative of physiological movements (2), and
- an imaging sampling grid (21) according to which the reconstruction of imaging signals is carried out,

the method being **characterized in that** it also comprises the implementation of an iterative repetition (31) comprising:

- constructing (4) a movement sampling grid (22, 32) by selecting a limited set of points from the imaging sampling grid (21), the points selected for constructing the movement sampling grid (22, 32) being chosen as a function of the movement parameters resulting from a preliminary estimation of said at least one movement model, so that the points from the movement sampling grid are in proximity to areas of the biological medium affected by comparatively greater movement variations and/or local deformations; and
- iterative repetition (33) comprising the implementation in an alternating manner of the following steps:

 • calculating movement parameters (12, 36) of each movement model by inversion of a linear system (10) at the points of said movement sampling grid (22) constructed, using a simulation model of an acquisition chain of the image (7), the acquisition chain being in the form of a linear simulation operator E ($\alpha$) that links an image to simulated experimental data,
 • estimating a reconstruction error (8) by calculating simulated experimental data from the previously estimated image (5, 34) with the simulation model of the acquisition chain and the calculated movement parameters,
 • calculate an error in the movements parameters by inversion, at the points of said movement sampling grid (22), of a linear system defining a linear relationship between small variations in the parameters of the movement model and a residual $\varepsilon$ representative of the estimated reconstruction error (9, 35);
 • estimation of the movement model by optimization (10) of the parameters of the movement model from the calculated error.

**2.** The method according to claim 1, in which the points selected for constructing the movement sampling grid (22, 32) are also chosen as a function of the following criterion: their proximity to areas of interfaces between structures or organs in the biological medium.

3. The method according to claim 2, in which the construction of the movement sampling grid (22, 32) also comprises steps of:

- classifying the points of the sampling grid (21) of an image of the biological medium (20) obtained beforehand according to a proximity criterion representative of their proximity to areas of interfaces between structures or organs in the biological medium, so as to constitute a list thereof,
- defining security areas around the points of the imaging sampling grid (21), the extent of which is an inverse function of the variation in the movement calculated with the movement model, and
- constituting the movement sampling grid (22) by going through the list of the classified points, starting from the points closest to the areas of interfaces between structures or organs in the biological medium, and retaining, for the construction of the movement sampling grid (22) only the points for which no point already belonging to the movement sampling grid (22) is located in their security area.

4. The method according to claim 3, in which the value of the proximity criterion is based on the norm of the gradient of the image at the point considered.

5. The method according to one of claims 3 or 4, in which the extent of the security area along the axes of the grid is an inverse function of the gradient of the movement along said respective axes.

6. The method according to any one of the previous claims, which also comprises a step (14, 37) of determining the movement parameters at the points of the imaging sampling grid by interpolation of the calculated values at the points of the movement sampling grid.

7. The method according to claim 6, which also comprises a step (14, 37) of calculating an interpolation matrix forming the link between the parameters of the movement model (12) at the points of the movement sampling grid (22) and at the points of the imaging sampling grid (21), said interpolation matrix calculation comprising steps of:

- producing a Delaunay triangulation between the points of the movement sampling grid (22), such that the points of the imaging sampling grid (21) not belonging to the movement sampling grid (22) are included in a single triangle in the case of a 2D image, or a single tetrahedron in the case of a 3D image respectively, the apexes of which are points of the movement sampling grid (22),
- calculating, for each point of the imaging sampling grid (21) considered, barycentric weighting coefficients in relation to the apexes of the triangle or tetrahedron including said point, defining the position of said point in relation to said apexes.

8. The method according to any one of the previous claims, implementing measurements representative of a plurality of physiological movements (2), and a plurality of movement models associated with said physiological movements, and comprising steps of constructing (4, 32) a plurality of movement sampling grids (22) for the different physiological movements, and calculating respective movement parameters (12, 36) according to said grids (22).

9. The method according to any one of the previous claims, in which the reconstruction of the imaging signals (6) comprises a step (5, 34) of inversion of a linear system describing a relationship between the experimental measurements (1) and the images (6, 20), and taking into account movement parameters (14, 33) determined beforehand at the points of the imaging sampling grid (21).

10. The method according to claim 9, in which the calculation of movement parameters (14, 33) at the points of the movement sampling grid (22) comprises a step of inversion (10, 36) of a linear system describing a relationship between, on the one hand, an error (9, 35) between experimental measurements (1) and measurements estimated from reconstructed imaging signals and, on the other hand, errors in the movement parameters calculated beforehand (13).

11. The method according to claim 10, in which the inversion (10, 36) of the linear system describing a relationship between the measurement errors (9, 35) and the errors in the movement parameters is carried out without explicit regularization.

12. The method according to any one of the previous claims, which also comprises an iterative repetition (33) of the steps of reconstructing (5, 34) the imaging signals (6) and calculating (10, 11, 36) movement parameters, for imaging sampling grids (21) of increasing spatial resolutions.

13. The method according to claim 1, which also comprises an iterative repetition of the steps of constructing of a selected movement sampling grid and an iterative repetition of the steps of calculating movement parameters of each movement model, in which, for a given iteration of the step of constructing a selected movement sampling grid, the points selected to construct said selected movement sampling grid are chosen using a criterion constructed according to the movement parameters of each calculated movement model in the previous iteration of the step of calculating the movement parameters of each movement model.

14. The method according to any one of the previous claims, for reconstructing imaging signals (6, 40) in a form chosen from a voxel, an image, a series of images, an MRI volume, and a series of MRI volumes.

15. The method according to any one of claims 1 to 13, for reconstructing imaging signals (6, 40) in the form of at least one spectrum of at least one NMR spectroscopy voxel.

16. The method according to any one of claims 1 to 13, for reconstructing imaging signals (6, 40) in a form chosen from a voxel, an image, a series of images, a volume and a series of volumes, originating from at least one medical image acquisition process among MRI, X-ray tomography, Positon Emission Tomography, single photon emission computed tomography and echography.

17. Device comprising medical imaging means and implementing the method for reconstructing imaging signals according to any one of the previous claims.

18. A device according to claim 17, comprising MRI imaging means and implementing the method according to any one of claims 1 to 13.

19. A device according to claim 17, comprising NMR spectroscopic imaging means and implementing the method according to any one of claims 1 to 11 and 14.

Figure 1

21

Figure 2

```
                 ┌─────────────────┐
                 │  initialisation │ ⟋ 30
                 │     α = 0       │
                 └─────────────────┘
                          │
                 ┌─────────────────┐
          ┌─────▶│ Boucle résolution r │ ⟋ 31
          │      │   (α, ρ₀)|_{r-1}    │
          │      └─────────────────┘
          │               │
          │      ┌─────────────────┐
          │      │ Grille mouvement │ ⟋ 32
          │      │  I_key, α_key    │
          │      └─────────────────┘
          │               │
          │      ┌─────────────────┐
      ┌──▶│      │ Boucle optimisation l │ ⟋ 33
      │   │      │   (α, ρ₀)|_{l-1}      │
      │   │      └─────────────────┘
      │   │               │
      │   │      ┌─────────────────┐
      │   │      │ Estimation image │ ⟋ 34
      │   │      │       ρ₀        │
      │   │      └─────────────────┘
      │   │               │
      │   │      ┌─────────────────┐
      │   │      │     Résidu      │ ⟋ 35
      │   │      │       ε         │
      │   │      └─────────────────┘
      │   │               │
      │   │      ┌─────────────────┐
      │   │      │  Optimisation   │ ⟋ 36
      │   │      │     α_key       │
      │   │      └─────────────────┘
      │   │               │
      │   │      ┌─────────────────┐
      │   │      │ Interpolation   │ ⟋ 37
      │   │      │ α = I_key α_key │
      │   │      └─────────────────┘
      │   │               │
      │   │    N    ◇───────────◇
      │   └────────│ Optimisation │ ⟋ 38
      │            │    OK ?      │
      │            ◇───────────◇
      │                  │ O
      │            N◇───────────◇
      └─────────────│ Résolution  │ ⟋ 39
                    │ Maximale ?  │
                    ◇───────────◇
                          │ O
                 ┌─────────────────┐
                 │ Solution image ρ₀ │ ⟋ 40
                 │   Modèle α       │
                 └─────────────────┘
```

Figure 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009098371 A, Odille F.

**Littérature non-brevet citée dans la description**

- Generalized reconstruction by inversion of coupled systems (GRICS) applied to free-breathing MRI. *Magnetic Résonance in Medicine,* 2008, vol. 60, 146-157

- **ERIK H. W. MEIJERING et al.** A fast technique for motion correction in DAS using a feature-based, irregular grid. *Medical Image Computing and Computer-Assisted Intervention - MICCAI'98, Lecture Notes in Computer Science (LNCS),* 2006, vol. 1496